# EUROPÄISCHE PATENTSCHRIFT

(11) **EP 3 457 568 B1**
(45) Veröffentlichungstag und Bekanntmachung des Hinweises auf die Patenterteilung: **08.09.2021**
(21) Anmeldenummer: 18183460.7
(22) Anmeldetag: 13.07.2018
(51) Int. Cl.: H03K 17/08, G11C 7/02, H03K 19/00, H03K 19/0175

(54) **STEUEREINGANGS-SCHUTZSCHALTUNG FÜR EIN ELEKTRISCHES GERÄT**
CONTROL INPUT PROTECTION CIRCUIT FOR AN ELECTRICAL DEVICE
CIRCUIT DE PROTECTION D'ENTRÉE DE COMMANDE POUR UN APPAREIL ÉLECTRIQUE

(30) Priorität: 13.09.2017 DE 102017216122
(43) Veröffentlichungstag der Anmeldung: 20.03.2019
(73) Patentinhaber: Robert Bosch GmbH, 70442 Stuttgart (DE)
(72) Erfinder: Krueger, Thomas, 31139 Hildesheim (DE)

(56) Entgegenhaltungen:
- EP-A1- 2 792 841
- JP-A- H03 268 608
- US-A1- 2009 086 104
- US-A1- 2010 164 544
- US-B2- 8 400 626

## Beschreibung

### Stand der Technik

Die Erfindung betrifft eine Steuereingangs-Schutzschaltung für ein elektrisches Gerät.

Steuereingänge eines Gerätes werden häufig über gleichspannungsgekoppelte Widerständen gegen ein Bezugspotenzial abgeschlossen, also mittels ohmscher Widerstände mit dem Bezugspotenzial, beispielsweise einer Schaltungsmasse, verbunden, um bei nicht vorliegendem Ansteuersignal für den Steuereingang einen elektrisch definierten Zustand zu erreichen. Diese sogenannten Pull-Down-Widerstände müssen entsprechend der durch das Ansteuersignal in diesen Widerständen erzeugten Verlustleistung dimensioniert werden. Die Baugröße der Widerstände hängt entscheidend von der maximal umzusetzenden Verlustleistung ab.

In automotiven Anwendungen ist es üblich, alle Steuereingänge eines Gerätes so auszulegen, dass auch das Anlegen der vollen Fahrzeugbatteriespannung von derzeit in der Regel 12V(olt) bei Personenkraftwagen, 24V bei Lastkraftwagen, nicht zur Zerstörung des Steuereingangs führt. Diese Anforderung führt dazu, dass die Widerstände gegen Masse an den Steuereingängen für deutlich mehr Verlustleistung dimensioniert werden müssen als es für den Normalbetrieb mit einem Ansteuersignal in der Größenordnung von wenigen, typischerweise maximal 5V, notwendig wäre. Dies ist besonders bei Steuereingängen für kleine, niederohmige Ansteuersignale der Fall, deren Signalamplitude gegenüber der Fahrzeugbatteriespannung klein ist. Als Folge wächst auch die Baugröße der Widerstände, die dann wertvollen Bauraum im Gerät belegen.

Die Druckschrift US 2010/164544 A1 beschreibt einen Ausgangstreiber für eine Halbleitereinrichtung, der eine Vor-Treibereinheit und eine Haupt-Treibereinheit umfasst. Die Vor-Treibereinheit erzeugt Treiber-Steuersignale basierend auf einem Datensignal. Die Haupt-Treibereinheit treibt einen Ausgangsanschluss in Reaktion auf die Steuersignale.

Die Druckschrift EP 2 792 841 A1 beschreibt ein Bohrlochwerkzeug zum Durchführen einer Operation in einem Bohrloch. Das Bohrlochwerkzeug umfasst einen elektrischen Motor, der mit Wechselstrom betrieben wird, und einen Freequenzumrichter, dessen zugeführte Spannung reduziert wird.

Die Druckschrift US 2011/0304847 A1 beschreibt eine Helligkeitssensorschaltung mit einem Mikroprozessor, einem Pullup-Widerstand und einem Pulldown-Widerstand, wobei die Widerstände an einen Eingangspin des Mikroprozessors gekoppelt sind.

Die Druckschrift JP H03 268608 A beschreibt ein Verfahren, mit dem ein ungewolltes Umkippen eines Logiksignals verhindert werden soll, um so die Störfestigkeit zu erhöhen.

### Vorteile der Erfindung

Die Erfindung mit den Merkmalen des unabhängigen Patentanspruchs hat den Vorteil, dass Steuereingänge von elektrischen Komponenten wirksam vor hohen Spannungen geschützt werden. So führt auch das Anlegen einer vollen Fahrzeugbatteriespannung oder einer anderen hohen Eingangsspannung nicht zur Zerstörung des Steuereingangs, obwohl Widerstände gegen Bezugspotenzial, insbesondere Masse, mit kleiner Bauform genutzt werden, die im begrenzten Bauraum des Gerätes untergebracht werden können. Weiterhin wird damit eine unerwünschte Erwärmung der elektrischen Komponente infolge hoher Verlustleistung am Pull-Down-Widerstand vermieden Weiterhin wird der erhöhte Ansteuerstrom beim Anlegen einer erhöhten Spannung des Ansteuersignals begrenzt, so dass keine Kontakte oder Leiterbahnen überlastet werden.

Die vorstehend skizzierten Vorteile werden erreicht mit einer Steuereingangs-Schutzschaltung für eine elektrische Komponente, welche elektrische Komponente über einen Steuereingang verfügt, der dazu ausgelegt ist, ein elektrisches Ansteuersignal zu empfangen, wobei der Steuereingang über einen elektrischen Widerstand mit einem Bezugspotential verbunden ist, wobei im Signalpfad zwischen dem Steuereingang und dem Bezugspotential zu dem elektrischen Widerstand ein elektrisch steuerbarer Schalter in Serie geschaltet ist, wobei der Schalter durch eine Steuerung steuerbar ist und wobei die Steuerung dazu ausgelegt ist, einen Spannungswert des Ansteuersignals mit einem vorgegebenen Grenzwert zu vergleichen und ein Steuersignal zum Öffnen des Schalters zu erzeugen, wenn der Spannungswert den Grenzwert überschreitet.

Es wird also einem Pull-Down-Widerstand, mit dem der Steuereingang der elektrischen Komponente gegen ein elektrisches Bezugspotenzial, beispielsweise Schaltungsmasse, abgeschlossen ist, ein Schalter in Serie geschaltet, welcher geöffnet wird, wenn am Steuereingang ein Ansteuersignal mit gegenüber einem festgelegten Grenzwert überhöhter elektrischer Spannung anliegt, sodass ein Stromfluss durch den Pull-Down-Widerstand und damit das Entstehen von Verlustleistung an dem Pull-Down-Widerstand unterbunden wird.

Diese Lösung ist auch für den Fall anwendbar, dass die elektrische Komponente über mindestens zwei Steuereingänge verfügt. Für diesen Fall sind die Steuereingänge vorzugsweise jeweils über einen elektrischen Widerstand und über einen gemeinsamen, mit den Widerständen in Reihe geschalteten elektrischen Schalter mit dem Bezugspotential verbunden sind. Die Steuerung ist dabei dazu ausgelegt, die Spannungswerte der an den Steuereingängen anliegenden Ansteuersignale mit einem vorgegebenen Grenzwert zu vergleichen und ein Steuersignal zum Öffnen des Schalters zu erzeugen, wenn der Spannungswert mindestens eines der Ansteuersignale den Grenzwert überschreitet. Anstelle eines gemeinsamen Grenzwertes für alle Steuereingänge können auch individuelle Schwellwerte für die einzelnen Steuereingänge vorgesehen werden.

Weiterhin ist das Bezugspotential durch eine Schaltungsmasse der elektrischen Komponente bestimmt. Weiterhin ist der Schalter im Signalpfad zwischen dem Steuereingang und dem Bezugspotential unmittelbar mit dem Bezugspotential verbunden.

Vorteilhaft kann der elektrische Widerstand, also der Pull-Down-Widerstand gegenüber einer Eingangsimpedanz des Steuereingangs niederohmig ausgelegt sein. Damit ist der Steuereingang der elektronischen Komponente gegenüber Überspannung auch dann geschützt, wenn gemäß der Erfindung der Signalpfad zwischen Steuereingang und Bezugspotenzial durch den dann geöffneten Schalter unterbrochen ist und somit das Ansteuersignal nicht über den Widerstand abfließen kann.

Unter einer elektrischen Komponente wird hier und im Folgenden ein elektrisches Gerät oder eine Baugruppe eines elektrischen Geräts verstanden. Dabei kann es sich insbesondere um ein Steuergerät zur Installation und Verwendung in einem Kraftfahrzeug handeln, wie beispielsweise ein Motor-Steuergerät, ein Airbag-Steuergerät, daneben beispielsweise um ein Multimedia- oder Fahrerinformationssystem. Solche Geräte oder Baugruppen von Geräten werden insbesondere im Bereich der Automobiltechnik oft im nicht sichtbaren Bereich und innerhalb beschränkten Bauraums angeordnet, wobei oftmals auch die Möglichkeiten zur aktiven oder passiven Kühlung der Geräte begrenzt sind.

Bei dem Ansteuersignal kann es sich beispielsweise um ein, gegebenenfalls geeignet vorverstärktes und/oder aufbereitetes Sensorsignal beispielsweise eines Beschleunigungssensors handeln, mit dem ein ungewöhnlicher Fahrzustand eines Fahrzeugs beispielsweise infolge Schleuderbewegung oder Aufprall auf ein Hindernis detektiert wird. Dieses Signal kann beispielsweise einem Steuereingang eines Airbag-Steuergeräts zugeführt sein, welches mittels eines elektrischen Zündsignals eine Zündladung zur Entfaltung des Airbags auslöst.

Bei dem Ansteuersignal kann es sich auch um ein Audiosignal einer Unterhaltungssignal- oder Informationsquelle, wie Rundfunkempfänger oder Navigationssystem mit Navigations-Sprachausgabe handeln, welches einem Steuereingang eines Audio-Signalverstärkers zugeführt ist, welcher wiederum angeschlossene Lautsprecher zur Ausgabe des Audiosignals treibt.

Unter dem Spannungswert des Ansteuersignals wird hier und im Folgenden der Betrag der Amplitude des Ansteuersignals, also die Amplitude der Spannung des Ansteuersignals, verstanden, welche mit einem gespeicherten oder erzeugten Grenzwert verglichen wird.

### Zeichnungen

Ausführungsbeispiele der Erfindung sind in den Zeichnungen dargestellt und werden nachfolgend näher erläutert. Gleiche Bezugszeichen in den Zeichnungen bezeichnen dabei gleiche oder gleichwirkende Elemente.

Es zeigen
Figur 1 ein Blockschaltbild einer nicht erfindungsgemäßen Steuereingangs-Schutzschaltung für eine elektrische Komponente
Figur 2 ein Blockschaltbild einer Variante der Steuereingangs-Schutzschaltung für eine elektrische Komponente mit in diesem Fall mindestens zwei oder einer Mehrzahl von Steuereingängen.

### Beschreibung der Ausführungsbeispiele

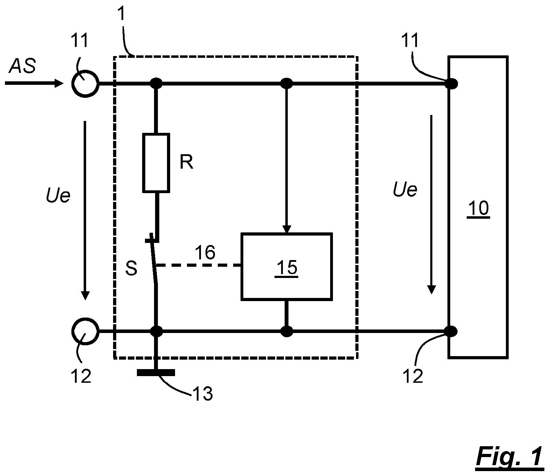

Figur 1 zeigt ein Blockschaltbild einer nicht erfindungsgemäßen Ausführungsform einer Steuereingangs-Schutzschaltung 1 für eine elektrische Komponente 10.

Die elektrische Komponente 10 weist einen Steuereingang auf, an den ein Ansteuersignal AS, beispielsweise eine Sensorsignal oder ein Audiosignal angelegt werden kann. Der Steuereingang 11 wird durch einen Eingangsanschluss 11 in Kombination mit einem Bezugspotenzialanschluss 12, hier Schaltungsmasse, der vorliegend mit Fahrzeugmasse 13 verbunden ist, gebildet. Das Ansteuersignal AS liegt als Eingangsspannungssignal Ue zwischen Eingangsanschluss 11 und Referenzpotenzialanschluss 12 an. Die Kursiv-Schreibung des Formelzeichens Ue wurde hier zur Verdeutlichung eines Ansteuersignals mit Wechsel-Anteil, also eines Nicht-Gleichspannungssignals gewählt.

Zwischen Eingangsanschluss 11 und Bezugspotenzialanschluss ist eine Reihenschaltung aus einem ohmschen Widerstand R und einem elektrisch steuerbaren Schalter S geschaltet. Dieser ist als Öffner ausgeführt, d.h. im Ruhezustand geschlossen, bei aktiver Ansteuerung durch ein Steuersignal 16 geöffnet. Der Schalter S kann vorzugsweise als Halbleiterschalter, beispielsweise in Form eines Feld-Effekt-Transistors (FET) mit geeigneter Beschaltung in an sich bekannter Weise ausgeführt sein. Der elektrisch steuerbare Schalter S wird vorliegend von einer Steuerung 15 angesteuert. Im Falle eines FET-Schalters S ist dazu die Gate-Elektrode des FET mit einem Steuersignalausgang der Steuerung 15 elektrisch verbunden.

Die Steuerung 15 ist einerseits mit dem Steuereingang 11, genauer mit dem Eingangsanschluss 11 verbunden. Die Steuerung 15 ist weiterhin mit dem Bezugspotenzialanschluss 12 und damit Schaltungsmasse sowie im vorliegenden Fall mit Fahrzeugmasse 13 verbunden. Die Steuerung 15 verfügt über einen Speicher oder ist mit einem Speicher verbunden, in dem ein Grenzwert für eine zulässige maximale Eingangsspannung Ue abgelegt ist. Der Speicher kann beispielsweise durch eine Zenerdiode gebildet sein, an der bei Anliegen einer Betriebsspannung eine konstante Spannung abfällt. Anderweitige Ausführungsformen des Speichers sind ebenso möglich.

Die Steuerung 15 ist dazu ausgebildet, das Steuersignal 16 zum Ansteuern des Schalters S auszugeben, sobald der Spannungswert des Ansteuersignals AS, also der Wert der Eingangsspannung Ue den gespeicherten Grenzwert überschreitet, und damit den Schalter S zu öffnen. Die Steuerung 15 wirkt somit als Vergleicher bzw. Komparator. Der Grenzwert kann für den hier vorgesehenen Einsatz im Bereich der Automobiltechnik beispielsweise auf 5V(olt) festgelegt sein. Der Grenzwert kann auch abweichend festgelegt sein, wobei hauptsächlich die in der elektrischen Komponente 10 unter Berücksichtigung eines je nach Anwendung ausreichenden oder gewünschten Signal-Stör-Abstandes benötigten Signalpegel bzw. Eingangssignal-Amplituden oder -höhen maßgebend sind. Daneben kann insbesondere auch eine gewünschte Auslegung des Widerstandes hinsichtlich einer maximal tolerierbaren Verlustleistung bei Höhe Eingangsspannung Ue im Nennbereich, also unterhalb des Grenzwertes, berücksichtigt werden.

Ist der Steuereingang 11 offen, das heißt nicht beschaltet und somit auch nicht mit einem Ansteuersignal AS bzw. einer Eingangsspannung Ue beaufschlagt, so bewirkt der Widerstand R in Verbindung mit dem dann geschlossenen Schalter S, dass der Eingangsanschluss 11 auf dem Bezugspotenzial und damit auch einem definierten Potenzial liegt.

Wird der Steuereingang 11 mit einem Ansteuersignal AS beaufschlagt, dessen Spannung oder Spannungs-Höchstwert unter dem Grenzwert liegt, so ist der Schalter S geschlossen und es fließt ein maßgeblich durch den Widerstand R begrenzter Strom über den Signalpfad aus Widerstand R und Schalter S, demzufolge im Widerstand eine Verlustleistung entsteht.

Wird der Schalter S geöffnet, sobald die Steuerung 15 ein Überschreiten des Grenzwertes durch das Ansteuersignal AS bzw. die Eingangsspannung Ue feststellt, so wird ein Stromfluss über den Signalpfad Eingangsanschluss 11 über Widerstand R und Schalter S zum Bezugspotentialanschluss 12 unterbunden, so dass am Widerstand R keine Spannung mehr abfällt und damit auch keine Verlustleistung entsteht.

Sobald die Spannung *Ue* am Steuereingang 11 den Schwellwert von hier beispielsweise 5V wieder unterschreitet, schließt die Steuerung 15 den Schalter S wieder. Der Schwellwert ist so gewählt, dass unterhalb des Schwellwertes der Widerstand R durch die anliegende Spannung Ue nicht überlastet wird und die Spannung im normalen Betriebszustand des Eingangs 11 den Schwellwert nicht überschreitet.

Bei dem in Figur 1 dargestellten Beispiel ist die Steuereingangs-Schutzschaltung 1 der elektrischen Komponente 10 vorgeschaltet, also als separate Baugruppe ausgeführt. Es ist jedoch ebenso möglich, die Steuereingangs-Schutzschaltung 1 als Teil der Komponente 10 auszuführen.

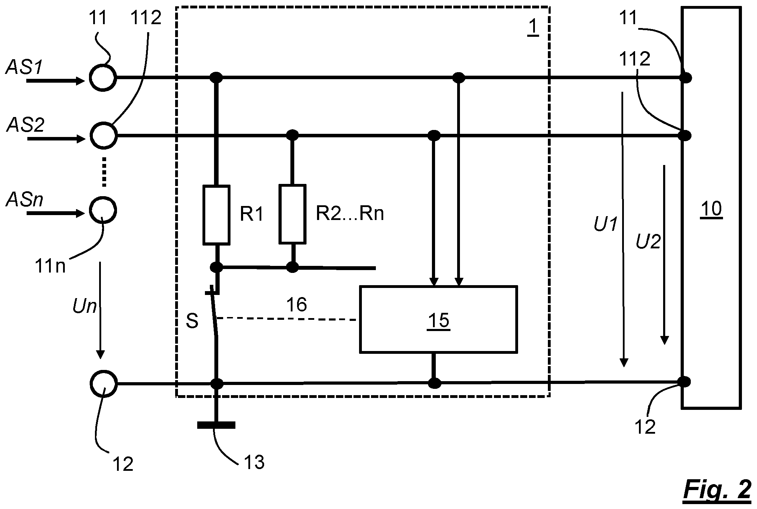

Figur 2 zeigt ein Blockschaltbild eine Steuereingangs-Schutzschaltung 1 für eine elektrische Komponente 10 mit in diesem Fall mindestens zwei oder einer Mehrzahl von Steuereingängen 11, 112. Der n-te Steuereingang 11n ist der Übersichtlichkeit halber hier nur als Bestandteil der Schutzschaltung 1 dargestellt. Den Steuereingängen 11, 112, ... 11n sind Ansteuersignale AS1, AS2, ..., ASn wie vorstehend bereits beschrieben, zuführbar, die als Eingangsspannungen U1, U2, ..., Un zwischen den Eingangsanschlüssen 11, 112, ..., 11n und dem Bezugspotentialanschluss 12, der auch hier Schaltungsmasse entspricht und mit Fahrzeugmasse 13 verbunden ist, anliegen.

Jeder der Steuereingänge 11, 112 und 11n ist mit einem Pull-Down-Widerstand R1, R2 und Rn verbunden. Die zweiten Anschlüsse der Pull-Down-Widerstände R1, R2, ..., Rn sind mit einem gemeinsamen elektrisch steuerbaren Schalter S verbunden, der hier wiederum vorzugsweise als Halbleiterschalter, beispielsweise FET ausgeführt ist und mit einem von der Steuerung 15 erzeugten Steuersignal 16 angesteuert wird.

Die Steuerung 15 ist mit jedem der Steuereingänge 11, 112 und 11n verbunden und dazu ausgelegt, ein Steuersignal 16 zum Öffnen des als Öffner ausgelegten elektrisch steuerbaren Schalters S zu erzeugen, wenn der Wert von mindestens einer der Spannungen *U1, U2,* ..., *Un* der Ansteuersignale AS1, AS2, ..., ASn den vorgegebenen Grenzwert von beispielsweise 5V überschreitet.

Somit sind bei diesem Ausführungsbeispiel die der Steuerung 15 zugeführten Ansteuersignale AS1, AS2, ..., ASn hinsichtlich der Bewertung bezüglich des Grenzwertes und damit der Erzeugung des Schalter-Steuersignals 16 logisch ODER-verknüpft.

In einer weiteren Ausführungsform kann auch vorgesehen werden, dass die Steuerung mehrere Schalter S steuert, die dann jeweils einen oder mehrere Pull-Down- Widerstände von dem Bezugspotenzial 12, beispielsweise Masse, trennen, wenn die Spannung des Ansteuersignals am betroffenen Steuereingang 11, 112, ..., 11n den Spannungs-Grenzwert überschreitet.

Daneben kann auch vorgesehen sein, dass für verschiedene von mehreren Steuereingängen 11, 112, ..., 11n verschiedene Spannungs-Grenzwerte vorgesehen werden. Dies ist mit beiden vorstehend skizzierten Ausführungsformen, also sowohl einem gemeinsamen Schalter S in Reihe geschaltet mit mehreren Widerständen R1, R2, ..., Rn, als auch separaten Schaltern, jeweils in Reihe geschaltet mit jeweils einem der mehreren Widerstände R1, R2, ..., Rn, umsetzbar.

## Patentansprüche

1. Steuereingangs-Schutzschaltung (1) für eine elektrische Komponente (10), welche über einen Steuereingang (11) verfügt, der dazu ausgelegt ist, ein elektrisches Ansteuersignal (AS) zu empfangen, wobei der Steuereingang (11) über einen elektrischen Widerstand (R), der als Pull-Down-Widerstand ausgebildet ist, mit einem Bezugspotential (12, 13) verbunden ist, wobei im Signalpfad zwischen dem Steuereingang (11) und dem Bezugspotential (12, 13) zu dem elektrischen Widerstand (R) ein elektrisch steuerbarer Schalter (S) in Serie geschaltet ist, wobei der Schalter (S) durch eine Steuerung (15) steuerbar ist, wobei die Steuerung (15) dazu ausgelegt ist, einen Spannungswert des Ansteuersignals (AS) mit einem vorgegebenen Grenzwert zu vergleichen und ein Steuersignal (16) zum Öffnen des Schalters (S) zu erzeugen, wenn der Spannungswert den Grenzwert überschreitet, wobei das Bezugspotential durch eine Schaltungsmasse der elektrischen Komponente bestimmt ist, und wobei der Schalter im Signalpfad zwischen dem Steuereingang und dem Bezugspotential unmittelbar mit dem Bezugspotential verbunden ist,
**dadurch gekennzeichnet, dass** die elektrische Komponente über mindestens zwei Steuereingänge (11, 112,...,11n) verfügt, dass die Steuereingänge jeweils über einen elektrischen Widerstand (R1, R2,...,Rn) und über den mit den Widerständen in Reihe geschalteten, gemeinsamen elektrischen Schalter (S) mit dem Bezugspotential (12, 13) verbunden sind, dass die Steuerung (15) dazu ausgelegt ist, die Spannungswerte der an den Steuereingängen (11, 112,..., 11n) anliegenden Ansteuersignale (AS1, AS2,...,ASn) mit einem vorgegebenen individuellen Grenzwert zu vergleichen und ein Steuersignal (16) zum Öffnen des Schalters (S) zu erzeugen, wenn der Spannungswert mindestens eines der Ansteuersignale (AS1, AS2,..., ASn) den Grenzwert überschreitet.

2. Steuereingangs-Schutzschaltung nach Anspruch 1, **dadurch gekennzeichnet, dass** der elektrische Widerstand gegenüber einer Eingangsimpedanz des Steuereingangs niederohmig ausgelegt ist.

## Claims

1. Control input protective circuit (1) for an electrical component (10), which has a control input (11), which is designed to receive an electrical drive signal (AS), wherein the control input (11) is connected to a reference potential (12, 13) via an electrical resistor (R), which is designed as a pull-down resistor, wherein an electrically controllable switch (S) is connected in series with the electrical resistor (R) in the signal path between the control input (11) and the reference potential (12, 13), wherein the switch (S) can be controlled by a controller (15), wherein the controller (15) is designed to compare a voltage value of the drive signal (AS) with a predetermined limit value and to generate a control signal (16) for opening the switch (S) when the voltage value exceeds the limit value, wherein the reference potential is determined by a circuit earth of the electrical component, and wherein the switch is connected directly to the reference potential in the signal path between the control input and the reference potential,
**characterized in that** the electrical component has at least two control inputs (11, 112, ..., 11n), **in that** the control inputs are each connected to the reference potential (12, 13) via an electrical resistor (R1, R2, ..., Rn) and via the common electrical switch (S) connected in series with the resistors, **in that** the controller (15) is designed to compare the voltage values of the drive signals (AS1, AS2, ..., ASn) applied to the control inputs (11, 112, ..., 11n) with a predetermined individual limit value and to generate a control signal (16) for opening the switch (S) when the voltage value of at least one of the drive signals (AS1, AS2, ..., ASn) exceeds the limit value.

2. Control input protective circuit according to Claim 1, **characterized in that** the electrical resistor is designed to be of low impedance with respect to an input impedance of the control input.

## Revendications

1. Circuit de protection d'entrée de commande (1) pour un composant électrique (10) qui dispose d'une entrée de commande (11) qui est conçue pour recevoir un signal d'excitation électrique (AS), l'entrée de commande (11) étant reliée à un potentiel de référence (12, 13) par l'intermédiaire d'une résistance électrique (R) qui est réalisée sous forme de résistance pull-down, un commutateur (S) à commande électrique étant connecté en série sur le chemin de signal entre l'entrée de commande (11) et le potentiel de référence (12, 13) jusqu'à la résistance électrique (R), le commutateur (S) pouvant être commandé par une commande (15), la commande (15) étant conçue pour comparer une valeur de tension du signal d'excitation (AS) avec une valeur limite prédéfinie et pour générer un signal de commande (16) pour ouvrir le commutateur (S) si la valeur de tension dépasse la valeur limite, le potentiel de référence étant déterminé par une masse de circuit du composant électrique, et le commutateur sur le chemin de signal entre l'entrée de commande et le potentiel de commande étant relié directement au potentiel de référence,
**caractérisé en ce que** le composant électrique dispose d'au moins deux entrées de commande (11, 112, ..., 11n), **en ce que** les entrées de commande sont reliées au potentiel de référence (12, 13) respectivement par l'intermédiaire d'une résistance électrique (R1, R2, ..., Rn) et par l'intermédiaire du commutateur électrique (S) commun, connecté en série avec les résistances, **en ce que** la commande (15) est conçue pour comparer les valeurs de tension des signaux d'excitation (AS1, AS2, ..., ASn) appliqués aux entrées de commande (11, 112, ..., 11n) avec une valeur limite individuelle prédéfinie et pour générer un signal de commande (16) pour ouvrir le commutateur (S) si la valeur de tension d'au moins l'un des signaux d'excitation (AS1, AS2, ..., ASn) dépasse la valeur limite.

2. Circuit de protection d'entrée de commande selon la revendication 1, **caractérisé en ce que** la résistance électrique est conçue à basse impédance par rapport à une impédance d'entrée de l'entrée de commande.
